# EUROPEAN PATENT APPLICATION

(11) **EP 4 722 806 A2**
(43) Date of publication of application: **08.04.2026**
(21) Application number: 25206531.3
(22) Date of filing: 02.10.2025
(51) Int. Cl.: G03F 1/24, G03F 1/58

(54) **REFLECTIVE MASK BLANK AND METHOD FOR MANUFACTURING REFLECTIVE MASK BLANK**

(30) Priority: 03.10.2024 JP 2024174189
(71) Applicant: SHIN-ETSU CHEMICAL CO., LTD., Tokyo 1000005 (JP)
(72) Inventor: KOSAKA, Takuro, Niigata, 942-8601 (JP); INAZUKI, Yukio, Niigata, 942-8601 (JP); OGOSE, Taiga, Niigata, 942-8601 (JP)
(74) Representative: Hindles Limited

(57) **Abstract**

A reflective mask blank used in EUV lithography using EUV light as exposure light comprising at least a substrate 10; a multilayer reflective film 50 that is formed on the substrate 10 and reflects exposure light; and a multilayer film 200 containing tantalum (Ta). The multilayer film 200 has a TaN part 210, a TaO part 230, and a Ta part 220 provided between the TaN part 210 and the TaO part 230. A density of the Ta part 220 is higher than densities of the TaN part 210 and the TaO part 230. The density of the Ta part 220 is 13 g/cm³ or more.

## Description

### Technical Field

The present invention relates to a reflective mask blank which is a material for a reflective mask used for manufacturing a semiconductor device such as an LSI, and a method for manufacturing a reflective mask blank.

### Background Art

In a process of manufacturing a semiconductor device, a photolithography technique of irradiating a transfer mask with exposure light and transferring a circuit pattern formed on the mask onto a semiconductor substrate (semiconductor wafer) via a reduction projection optical system is repeatedly used. In the related art, a wavelength of exposure light is mainly 193 nm obtained by using argon fluoride (ArF) excimer laser light, and a pattern having dimensions smaller than an exposure wavelength has been finally formed by employing a process called multi-patterning in which an exposure process and a processing process are combined a plurality of times.

However, since there is a demand for formation of even finer patterns due to continuous miniaturization of device patterns, an extreme ultraviolet (hereinafter referred to as "EUV") lithography technique using EUV light having a wavelength even shorter than that of ArF excimer laser light as exposure light has come into use. The EUV light is light having a wavelength of about 0.2 to 100 nm, more specifically, light having a wavelength of about 13.5 nm. This EUV light has extremely low transmittance through a substance, and a transmissive projection optical system or mask of the related art cannot be used, so that a reflective optical element is used. Therefore, a reflective mask is also used as a mask for pattern transfer.

The reflective mask includes a multilayer reflective film that is formed on a substrate and reflects EUV light and an absorber film that absorbs EUV light on the multilayer reflective film and is formed in a pattern. Meanwhile, a mask blank in a state before patterning is performed on the absorber film (also including a state in which a resist film is formed) is called a reflective mask blank, and the reflective mask blank is used as a material of the reflective mask.

The reflective mask blank generally has a basic structure including a substrate having low thermal expansion, a multilayer reflective film that reflects EUV light and is formed on one (front surface) of two main surfaces of the substrate, and an absorber film that absorbs EUV light and is formed on the multilayer reflective film. As the multilayer reflective film, a multilayer reflective film that obtains a reflectance suitable for EUV light by alternately laminating a molybdenum (Mo) layer and a silicon (Si) layer is usually used. Meanwhile, as the absorber film, tantalum (Ta) or the like having a relatively high value of an extinction coefficient with respect to EUV light is used (JP 2002-246299 A). Further, as a protective film for protecting the multilayer reflective film, a ruthenium (Ru) film is formed on the multilayer reflective film as disclosed in JP 2002-122981 A.

In addition, as an etching mask during pattern formation in the absorber film, a hard mask film may be formed on the absorber film. As the hard mask film, a material that can ensure a selection ratio between the absorber film and etching is selected.

Meanwhile, a back conductive film is formed on the other main surface (back surface) of the substrate. As the back conductive film, a metal nitride film has been proposed for electrostatic chucking, and examples thereof mainly include a film containing chromium (Cr), tantalum (Ta), or the like.

### SUMMARY OF INVENTION

### PROBLEM TO BE SOLVED BY INVENTION

In a case where the film containing tantalum (Ta) is, for example, an absorber film, a tantalum oxide (TaO) part and a tantalum nitride (TaN) part may be formed by forming a tantalum oxide (TaO) part as a reflectance reduction layer on a front surface to reduce a reflectance at an inspection wavelength when the absorber layer of the absorber film contains tantalum nitride (TaN). In a case where a film including a tantalum nitride (TaN) part and a tantalum oxide (TaO) part is formed, a TaON layer is formed to a considerable extent on an interface between the tantalum nitride (TaN) part and the tantalum oxide (TaO) part. However, in the vicinity of this interface having a TaON composition, the individual elements partially tend to form a stable structure, and precipitation of crystals or the like may occur. Particularly during film formation, in a case where a film is formed using the same chamber and the same target, an intermediate layer of TaON is likely to be formed thick, and the precipitation of crystals or the like is likely to occur. In a case where the precipitation of crystals occurs in the film, there is a concern that surface roughness, a pattern shape, or lithographic characteristics of the film may deteriorate, and this is not preferable.

The present invention has been made to solve the problems described above, and an object of the present invention is to provide a reflective mask blank and a method for manufacturing the reflective mask blank, which enables a reflective mask having low surface roughness and having excellent defect inspection sensitivity to be manufactured.

### MEANS FOR SOLVING PROBLEM

The inventors of the present application have found that a smooth film having a multilayer structure including a TaN part and a TaO part can be formed without precipitating crystals at an interface between the TaN part and the TaO part by adding a Ta part containing Ta between the TaN part and the TaO part and having a density of 13 g/cm³ or more which is higher than that of the TaN part and the TaO part, and this has led to the present invention.

Hence, the present invention provides the following reflective mask blank.

A reflective mask blank used in EUV lithography using EUV light as exposure light according to the present invention comprise at least a substrate; a multilayer reflective film that is formed on the substrate and reflects exposure light; and a multilayer film containing tantalum (Ta),
wherein the multilayer film has a TaN part, a TaO part, and a Ta part provided between the TaN part and the TaO part,
wherein a density of the Ta part is higher than densities of the TaN part and the TaO part, and
wherein the density of the Ta part is 13 g/cm³ or more.

In the reflective mask blank according to the present invention,
the TaN part, the Ta part, and the TaO part may be laminated in this order from the substrate side in the multilayer film.

In the reflective mask blank according to the present invention,
a film thickness of the Ta part may be 1 nm or more and less than 3 nm.

In the reflective mask blank according to the present invention,
the TaN part may be substantially free of oxygen and contains less than 70 atom% of tantalum (Ta) and more than 30 atom% of nitrogen (N).

In the reflective mask blank according to the present invention,
the TaO part may be substantially free of nitrogen (N), and contains less than 70 atom% of tantalum (Ta) and more than 30 atom% of oxygen (O) or
the TaO part may contain less than 5 atom% of any one or more kinds of boron (B), carbon (C), hydrogen (H), and silicon (Si) in addition to tantalum (Ta) and oxygen (O).

In the reflective mask blank according to the present invention,
the Ta part may contain substantially no element other than tantalum (Ta), or
a total content of nitrogen (N) and oxygen (O) may be less than 20 atom% in the Ta part.

In the reflective mask blank according to the present invention,
the multilayer film may function as an absorber film.

The reflective mask blank according to the present invention may further comprise a hard mask film that is used as an etching mask during processing of the multilayer film functioning as the absorber film,
the hard mask film may contain chromium (Cr).

In the reflective mask blank according to the present invention,
multilayer film may have a first multilayer film having a first TaN part, a first TaO part, and a first Ta part provided between the first TaN part and the first TaO part, and a second multilayer film having a second TaN part, a second TaO part, and a second Ta part provided between the second TaN part and the second TaO part,
the first multilayer film may function as an absorber film,
the second multilayer film may function as a hard mask film used as an etching mask during processing of the first multilayer film that is the absorber film,
a film thickness of the first multilayer film may be 55 nm or more and less than 70 nm, and
a film thickness of the second multilayer film may be 20 nm or less.

In the reflective mask blank according to the present invention,
the Ta part may be formed between the TaN part and the TaO part by forming a film of Ta under oxygen- and nitrogen-free atmosphere.

In the reflective mask blank according to the present invention,
the film of Ta may be formed under the oxygen- and nitrogen-free atmosphere to form the Ta part after the TaN part is formed, and
wherein a surface of the Ta part on a side away from the substrate is oxidized to form the TaO part.

### EFFECT OF INVENTION

According to the present invention, a reflective mask blank and a method for manufacturing the reflective mask blank, which enables a reflective mask having low surface roughness and having excellent defect inspection sensitivity to be manufactured, are provided.

### BRIEF DESCRIPTION OF DRAWINGS

FIG. 1 is a longitudinal-sectional view illustrating an aspect in which a multilayer film functions as an absorber film in a reflective mask blank according to an embodiment of the present invention;
FIG. 2 is a longitudinal-sectional view illustrating an aspect in which the multilayer film functions as the absorber film and a hard mask film in the reflective mask blank according to the embodiment of the present invention;
FIG. 3 is a longitudinal-sectional view illustrating an example of a configuration of the multilayer film in the aspect in which the multilayer film functions as the absorber film according to the embodiment of the present invention;
FIG. 4 is a longitudinal-sectional view illustrating another example of the configuration of the multilayer film in the aspect in which the multilayer film functions as the absorber film according to the embodiment of the present invention;
FIG. 5 is a longitudinal-sectional view illustrating an example of the configuration of the multilayer film in the aspect in which the multilayer film functions as the absorber film and the hard mask film according to the embodiment of the present invention;
FIG. 6 is a longitudinal-sectional view illustrating an aspect in which a TaN part of the multilayer film functions as an absorber film, and a TaO part functions as a hard mask film according to the embodiment of the present invention;
FIG. 7 is a longitudinal-sectional view illustrating an aspect in which an auxiliary layer is provided on a lower surface of the multilayer film according to the embodiment of the present invention;
FIG. 8 is a longitudinal-sectional view illustrating an aspect in which an auxiliary layer is provided on an upper surface of the multilayer film according to the embodiment of the present invention;
FIG. 9 is a longitudinal-sectional view illustrating an aspect in which a resist film is provided in the reflective mask blank according to the embodiment of the present invention;
FIG. 10 is a longitudinal-sectional view illustrating an aspect in which the resist film and the hard mask film are patterned in the reflective mask blank according to the embodiment of the present invention;
FIG. 11 is a longitudinal-sectional view illustrating an aspect in which the absorber film is patterned in the reflective mask blank according to the embodiment of the present invention.

### DETAILED DESCRIPTION

Hereinafter, an embodiment of the present invention will be described.

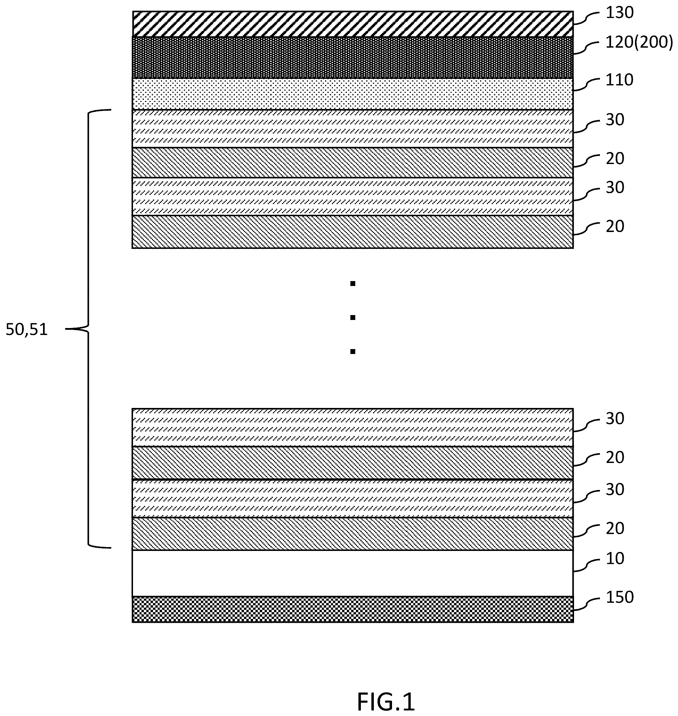

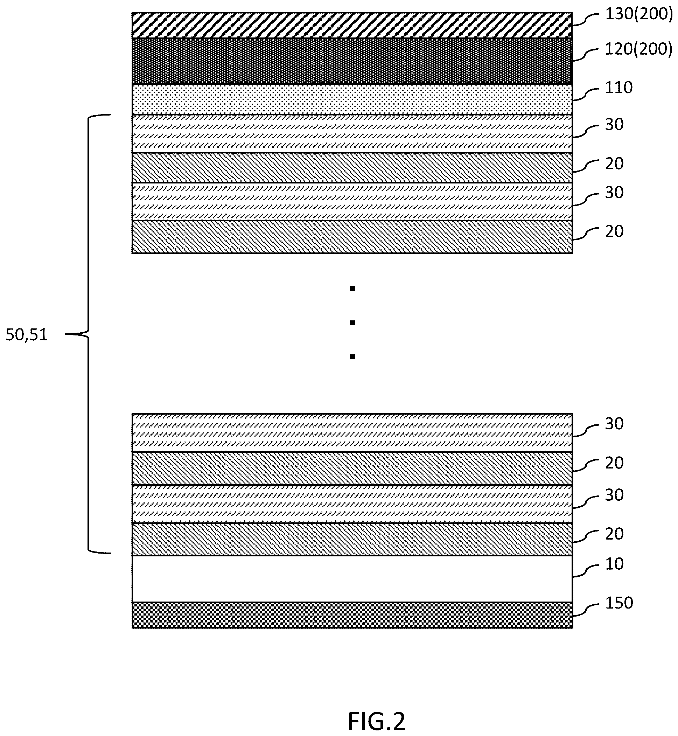

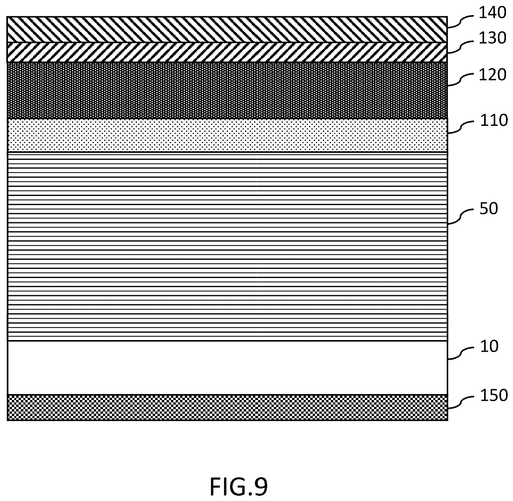

As illustrated in FIGS. 1 and 2, a reflective mask blank of the embodiment has a substrate 10, a multilayer reflective film 50 that is formed on one main surface (front surface) of the substrate 10 and reflects exposure light, and an absorber film 120 that absorbs the exposure light. A protective film 110 that protects the multilayer reflective film 50 may be provided between the multilayer reflective film 50 and the absorber film 120. A hard mask film 130 may be further formed on a front surface (upper surface) of the absorber film 120. A back conductive film 150 may be formed on a back surface (lower surface) of the substrate 10. In addition, as illustrated in FIG. 9, a resist film 140 may be formed on a front surface (upper surface) of the hard mask film 130.

A reflective mask blank of the embodiment is suitable as a material of a reflective mask used in EUV lithography using EUV light as exposure light. A wavelength of the EUV light used for EUV lithography using the EUV light as the exposure light is 13 to 14 nm, and the EUV light is usually light having a wavelength of about 13.5 nm. The reflective mask blank and the reflective mask using the EUV light as the exposure light are also referred to as an EUV mask blank and an EUV mask, respectively.

The reflective mask blank used in EUV lithography using the EUV light as the exposure light according to the embodiment has at least the substrate 10, the multilayer reflective film 50 that is formed on the substrate 10 and reflects exposure light, and a multilayer film 200 containing tantalum.

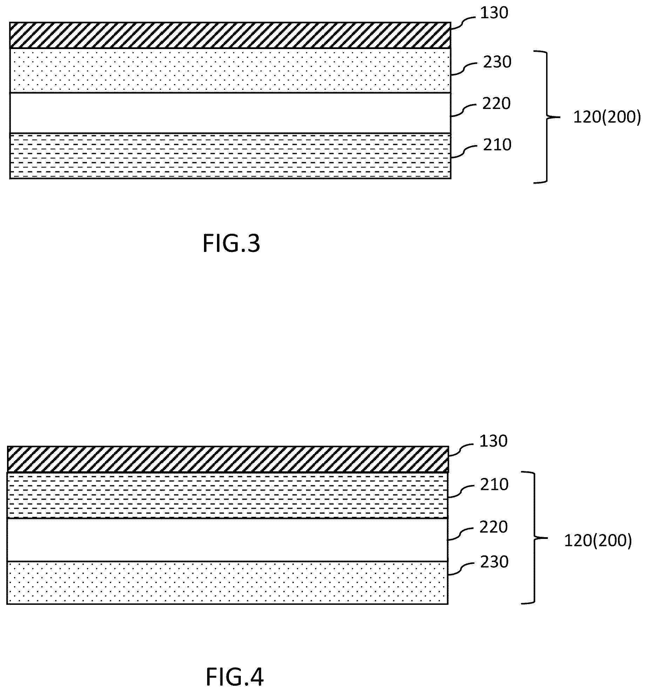

As illustrated in FIGS. 3 and 4, the multilayer film 200 containing tantalum has a tantalum nitride (TaN) part 210, a tantalum oxide (TaO) part 230, and a tantalum (Ta) part 220 provided between the TaN part 210 and the TaO part 230. A density of the Ta part 220 is higher than densities of the TaN part 210 and the TaO part 230. The density of the Ta part 220 is 13 g/cm³ or more. In this manner, precipitation of crystals can be prevented from occurring at an interface between the TaO part 230 and the TaN part 210, and a decrease in surface roughness can be prevented.

The tantalum nitride (TaN) part 210 is a layer mainly made of tantalum and nitrogen, the tantalum oxide (TaO) part 230 is a layer mainly made of tantalum and oxygen, and the Ta part 220 contains tantalum.

The Ta part 220 is preferably a film having a smaller amount of oxygen than that of the tantalum oxide (TaO) part 230 and a smaller amount of nitrogen than that of the tantalum nitride (TaN) part 210.

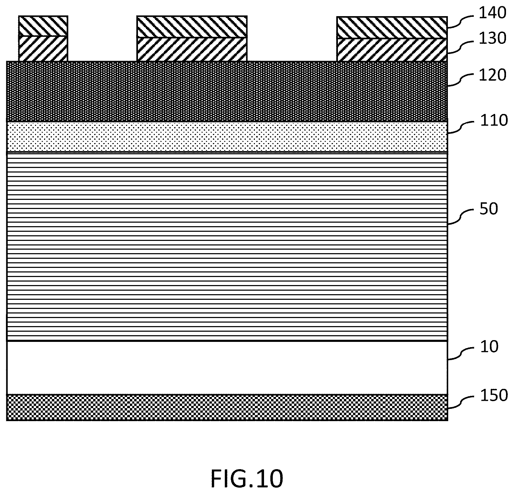

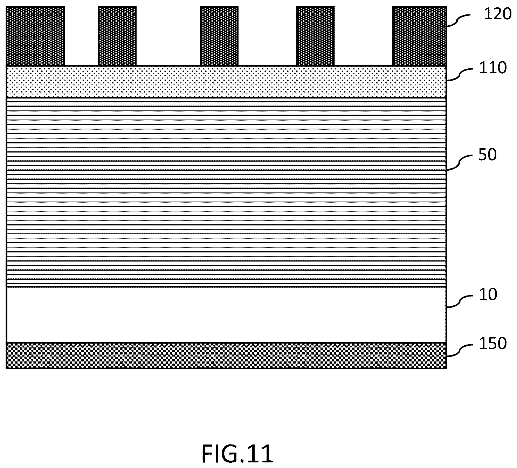

The multilayer film 200 containing tantalum can be a pattern-formed film, and examples of the pattern-formed film include the absorber film 120 and the hard mask film 130 (see FIGS. 10 and 11).

In the multilayer film 200, the TaN part 210, the Ta part 220, and the TaO part 230 are preferably laminated in this order from the substrate 10 side (a back surface side of the reflective mask blank) (see FIG. 3). By forming the multilayer film in this manner, for example, when the multilayer film is used as the absorber film 120, the reflectance can be easily reduced at an inspection wavelength. In addition, since the TaO part 230 has etching characteristics different from those of the TaN part 210, the TaO part 230 can be used as an etching mask (hard mask) of the TaN part 210 at the time of pattern formation.

However, the embodiment is not limited to such an aspect, and in the multilayer film 200, the TaO part 230, the Ta part 220, and the TaN part 210 may be laminated in this order from the substrate 10 side (the back surface side of the reflective mask blank) (see FIG. 4).

The density of the Ta part 220 is preferably 13 g/cm³ or more and 17 g/cm³ or lower, and more preferably 16 g/cm³ or lower.

The density of the TaN part 210 is preferably 10 g/cm³ or more and 12 g/cm³ or lower.

The density of the TaO part 230 is preferably 3 g/cm³ or more and 10 g/cm³ or lower.

A film thickness of the Ta part 220 is preferably 1 nm or more and less than 3 nm. When the film thickness of the Ta part 220 becomes thinner than 1 nm and the film thickness becomes too thin, the crystal precipitation preventing effect is weakened. On the other hand, when the film thickness of the Ta part 220 is 3 nm or more, crystal growth of Ta occurs, or the like. This is disadvantageous in that film stress increases, surface roughness deteriorates, irradiation resistance to exposure light deteriorates, or the like.

The TaN part 210 is substantially free of oxygen and preferably contains less than 70 atom% of tantalum (Ta) and more than 30 atom% of nitrogen (N). The phrase "substantially free of oxygen" means that the content of oxygen is 2 atom% or less.

The TaO part 230 is substantially free of nitrogen (N), and preferably contains less than 70 atom% of tantalum (Ta) and more than 30 atom% of oxygen (O) or contains less than 5 atom% of any one or more kinds of boron (B), carbon (C), hydrogen (H), and silicon (Si) in addition to tantalum (Ta) and oxygen (O). The phrase "substantially free of nitrogen" means that the content of nitrogen is 2 atom% or less.

A composition of the Ta part 220 preferably contains substantially no element other than tantalum (Ta), or the total content of nitrogen (N) and oxygen (O) is less than 20 atom%. The phrase "to contain substantially no element other than tantalum (Ta)" means that the content of tantalum is 95 atom% or more. Note that, from the viewpoint of reducing the surface roughness, it is preferable to employ an aspect in which the Ta part 220 contains substantially no element other than tantalum (Ta).

The absorber film 120 can have a multilayer structure including at least all of the individual parts of at least the TaN part 210, the Ta part 220, and the TaO part 230 (see FIG. 1).

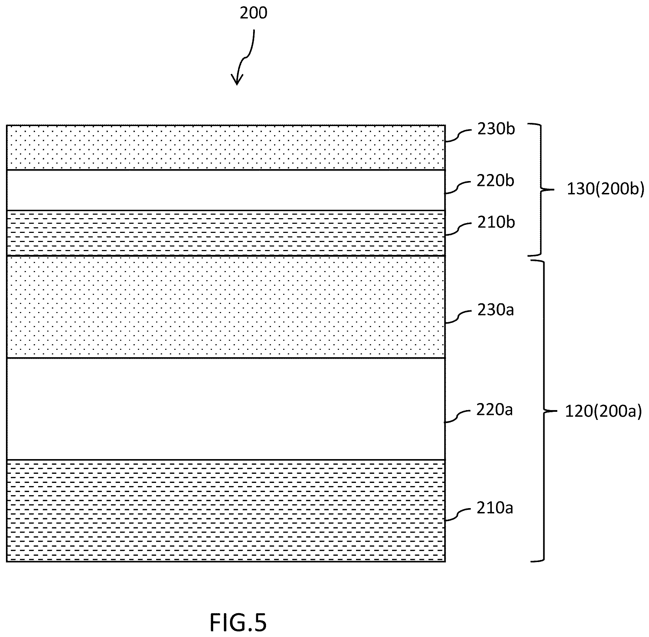

In addition, the absorber film 120 and the hard mask film 130 can both have a multilayer structure including the individual parts of the TaN part 210, the Ta part 220, and the TaO part 230 (see FIG. 2). In this case, as illustrated in FIG. 5, the multilayer film 200 may have a first multilayer film 200a having a first TaN part 210a, a first TaO part 230a, and a first Ta part 220a provided between the first TaN part 210a and the first TaO part 230a, and a second multilayer film 200b having a second TaN part 210b, a second TaO part 230b, and a second Ta part 220b provided between the second TaN part 210b and the second TaO part 230b. The first multilayer film 200a may function as the absorber film 120. The second multilayer film 200b may function as the hard mask film 130 used as an etching mask during processing of the first multilayer film 200a which is the absorber film 120. In a case where the first multilayer film 200a functions as the absorber film 120, a film thickness of the first multilayer film 200a is preferably 55 nm or more and less than 70 nm. In a case where the second multilayer film 200b functions as the hard mask film 130, a film thickness of the second multilayer film 200b is preferably 20 nm or less.

In addition, the absorber film 120 may include only the multilayer film 200 including only the TaN part 210, the Ta part 220, and the TaO part 230. In this case, a film containing Cr (a Cr-containing film) may be used as the hard mask film 130 used as the etching mask during processing of the absorber film 120 (see FIGS. 3 and 4).

In addition, the TaN part 210 and the TaO part 230 may function as the absorber film 120 in which a pattern is formed and the hard mask film 130 that is used as the etching mask during processing of the absorber film 120, respectively. In this manner, etching selectivity can be achieved.

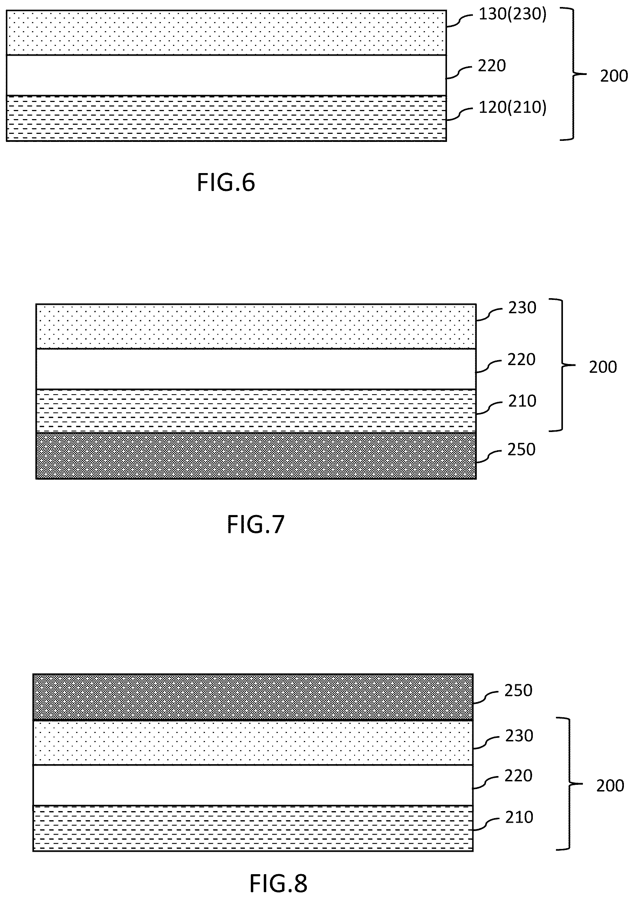

In particular, as illustrated in FIG. 6, the absorber film 120 may include the TaN part 210, and the hard mask film 130 may include the TaO part 230. In this case, the Ta part 220 functions as, for example, a part of the absorber film 120.

The absorber film 120 may have a phase shift function. In addition, a lower part of the absorber film 120 may have a structure having a layer (buffer layer) having resistance to etching conditions during pattern formation and pattern correction of an upper part of the absorber film.

In a case where a layer containing Ta is used as the absorber film 120, the absorber film 120 may include only the multilayer film 200 containing Ta, but may have a layer containing one or more of Ru, Rh, Ir, Pt, Nb, and Cr. The multilayer film 200 containing Ta may be provided on a side of a layer 250 containing one or more of Ru, Rh, Ir, Pt, Nb, and Cr, the side being away from the substrate 10, (see FIG. 7). In addition, the layer 250 containing one or more of Ru, Rh, Ir, Pt, Nb, and Cr may be provided on the side of the multilayer film 200 which is away from the substrate 10 (see FIG. 8). In this case, since the multilayer film 200 containing Ta provided on the substrate 10 side of the layer 250 containing one or more of Ru, Rh, Ir, Pt, Nb, and Cr can be a layer functioning as the buffer layer, and this is preferable.

The multilayer film 200 containing Ta can be formed by sputtering, and the sputtering is preferably magnetron sputtering. For example, the multilayer film 200 can be formed by reactive sputtering using a tantalum (Ta) target and using, as a sputtering gas, a nitrogen (N₂) gas or an oxygen (O₂) gas depending on a film composition together with a rare gas such as a helium (He) gas, a neon (Ne) gas, an argon (Ar) gas, a krypton (Kr) gas, or a xenon (Xe) gas.

The Ta part 220 may be formed as a film of Ta between the tantalum nitride (TaN) part 210 and the tantalum oxide (TaO) part 230 in an oxygen- and nitrogen-free atmosphere, for example.

In addition, after the tantalum nitride (TaN) part 210 is formed, a film of Ta may be formed under the oxygen- and nitrogen-free atmosphere to form the Ta part 220, and thereafter, a surface (front surface) of the Ta part 220 on a side away from the substrate 10 may be oxidized to form the tantalum oxide (TaO) part 230 on the front surface of the Ta part 220.

As a heat treatment, for example, heating may be performed in an oxygen-containing atmosphere such as air at a temperature of 120°C or more and 200°C or lower for five to sixty minutes, for example, by a hot plate type heating device.

The substrate 10 preferably has low thermal expansion characteristics for EUV light exposure, and for example, is preferably made of a material having a thermal expansion coefficient within a range of ±2 × 10⁻⁸/°C, preferably within a range of ±5 × 10⁻⁹/°C. Examples of the material include titania-doped quartz glass (SiO₂-TiO₂-based glass). In addition, it is preferable to use the substrate 10 having a sufficiently flattened surface, and the surface roughness of a main surface of the substrate 10 is preferably 0.5 nm or lower, and particularly preferably 0.2 nm or lower in terms of an RMS value. The surface roughness can be obtained by performing polishing or the like on the substrate 10. Regarding the size of the substrate 10, the substrate 10 has a main surface size of 152 mm × 152 mm, and the substrate 10 has a thickness of 6.35 mm. The substrate 10 having this size is the substrate 10 (the substrate 10 having a main surface size of 6 inches square and a thickness of 0.25 inches) referred to as the so-called 6025 substrate 10.

The multilayer reflective film 50 is a film that reflects exposure light in the reflective mask. The multilayer reflective film 50 is preferably provided in contact with one main surface (front surface) of the substrate 10, but another film such as a base film may be provided between the multilayer reflective film and the one main surface of the substrate 10. The multilayer reflective film 50 has a cyclic lamination structure 51 in which a high-refractive-index layer 20 having a relatively high refractive index to the exposure light and a low-refractive-index layer 30 having a relatively low refractive index to the exposure light are alternately laminated (see FIGS. 1 and 2).

The high-refractive-index layer 20 is preferably made of a material containing silicon (Si). The high-refractive-index layer 20 may contain one or more additive elements selected from oxygen (O), nitrogen (N), carbon (C), boron (B), and hydrogen (H) and may include a multilayer of a layer containing an additive element and a layer which contains no additive element. A thickness of the high-refractive-index layer 20 is preferably 3.5 nm or more and more preferably 4 nm or more, and preferably 4.9 nm or less and more preferably 4.4 nm or less.

The low-refractive-index layer 30 is preferably made of a material containing molybdenum (Mo). In addition, the low-refractive-index layer 30 can also be made of a material containing ruthenium (Ru). The low-refractive-index layer 30 may contain one or more additive elements selected from oxygen (O), nitrogen (N), carbon (C), boron (B), and hydrogen (H) and may include a multilayer of a layer containing an additive element and a layer which contains no additive element. A thickness of the low-refractive-index layer 30 is preferably 2.1 nm or more and more preferably 2.6 nm or more and is preferably 3.5 nm or less and more preferably 3 nm or less.

The cyclic lamination structure 51 may include the high-refractive-index layer 20 and the low-refractive-index layer 30 or may include one or more high-refractive-index layers 20 and one or more low-refractive-index layers 30 in one cycle. The number of layers included in the cyclic lamination structure 51 is two or more, and the cyclic lamination structure 51 can include, for example, one layer of the high-refractive-index layer 20 and one layer of the low-refractive-index layer 30. In addition, two or more layers of the high-refractive-index layers 20 having different compositions (for example, different composition ratios, different compositions depending on containing or non-containing of the additive element, or the like) from each other may be included, or two or more layers of the low-refractive-index layers 30 having different compositions (for example, different composition ratios, different compositions depending on containing or non-containing of the additive element, or the like) from each other may be included. In this case, the number of layers included in the cyclic lamination structure 51 is three or more and may be four or more or five or more, but is preferably eight or less. The number of cycles is preferably 30 or more, preferably 50 or less, and more preferably 40 or less. In a case where the low-refractive-index layer 30 is made of a material containing ruthenium (Ru), a layer (uppermost layer) farthest away from the substrate 10 of the cyclic lamination structure 51 is preferably the high-refractive-index layer 20.

A thickness of the multilayer reflective film 50 having the cyclic lamination structure 51 is adjusted depending on an exposure wavelength and an incident angle of the exposure light and is preferably 200 nm or more and more preferably 270 nm or more and is preferably 400 nm or less and more preferably 290 nm or less.

Examples of a method for forming the multilayer reflective film 50 include a sputtering method in which power is supplied to a target, an atmospheric gas is converted into plasma (ionized) with the supplied power, and sputtering is performed, and an ion beam sputtering method in which a target is irradiated with an ion beam. Examples of the sputtering method include a DC sputtering method in which a DC voltage is applied to a target, and an RF sputtering method in which a high-frequency voltage is applied to a target. The sputtering method is a film forming method in which a voltage is applied to a target in a state in which a sputtering gas is introduced into a chamber, the gas is ionized, and a sputtering phenomenon by gas ions is used. In particular, a magnetron sputtering method is advantageous in terms of productivity. The power applied to the target may be DC or RF, and examples of a DC sputtering method also includes pulse sputtering in which a negative bias applied to the target is inverted in a short time in order to prevent the target from being charged up.

The multilayer reflective film 50 can be formed, for example, by a sputtering method using a sputtering apparatus to which a plurality of targets can be loaded. Specifically, the multilayer reflective film can be formed by appropriately selecting from and using, as the target, a molybdenum (Mo) target for forming a layer containing molybdenum (Mo), a ruthenium (Ru) target for forming a layer containing ruthenium (Ru), a silicon (Si) target for forming a layer containing silicon (Si), and the like and using, as a sputtering gas, a rare gas such as a helium (He) gas, an argon (Ar) gas, a krypton (Kr) gas, or a xenon (Xe) gas.

In addition, in a case where sputtering is reactive sputtering using a reactive gas, for example, a nitrogen-containing gas such as a nitrogen (N₂) gas when a film containing nitrogen (N) is formed, an oxygen-containing gas such as an oxygen (O₂) gas when a film containing oxygen (O) is formed, a nitrogen oxide gas such as a nitrous oxide (N₂O) gas, a nitrogen monoxide (NO) gas, or a nitrogen dioxide (NO₂) gas when a film containing nitrogen (N) and oxygen (O) is formed, a carbon oxide gas such as a carbon monoxide (CO) gas or a carbon dioxide (CO₂) gas when a film containing carbon (C) and oxygen (O) is formed, a hydrogencontaining gas such as a hydrogen (H₂) gas when a film containing hydrogen (H) is formed, or a hydrocarbon gas such as a methane (CH₄) gas when a film containing carbon (C) and hydrogen (H) is formed may be used together with a rare gas.

Further, when a layer containing boron (B) is formed, a molybdenum (Mo) target to which boron (B) is added (molybdenum boride (MoB) target), a silicon (Si) target to which boron (B) is added (silicon boride (SiB) target), or the like can be used.

As illustrated in FIGS. 1 and 2, the protective film 110 may be provided on the multilayer reflective film 50. The protective film 110 is also referred to as a capping film. The protective film 110 is a film for protecting the multilayer reflective film 50. The protective film 110 is usually provided in contact with the multilayer reflective film 50. The protective film 110 is made of a material containing ruthenium (Ru).

Examples of the material containing ruthenium (Ru) include elemental ruthenium (Ru) and an alloy containing ruthenium (Ru) and a metal or a metalloid different from ruthenium (Ru). Examples of the metal or the metalloid different from ruthenium (Ru) include niobium (Nb), rhenium (Re), zirconium (Zr), titanium (Ti), chromium (Cr), and silicon (Si). A content of a metal or a metalloid different from ruthenium (Ru) in the protective film 110 is preferably 30 atom% or less and more preferably 20 atom% or less. The lower limit of the content of the metal or the metalloid different from ruthenium (Ru) in the protective film 110 is not particularly limited and is preferably 5 atom% or more and more preferably 10 atom% or more.

The protective film 110 may have a single layer structure or a multilayer structure in which a plurality of layers having different compositions are combined, and one single layer and individual layers constituting the plurality of layers may have a gradient composition structure in which the composition continuously changes in a thickness direction. In particular, one or both of a side of the protective film 110 which is close to the multilayer reflective film 50 (in the case of the multilayer structure, a layer close to the multilayer reflective film 50) and a side thereof which is farthest away from the multilayer reflective film 50 (in the case of the multilayer structure, a layer farthest away from the multilayer reflective film 50) can be made of ruthenium (Ru).

In addition, in a case where the protective film 110 has the multilayer structure or the gradient composition structure, it is preferable that the content of a metal or a metalloid different from ruthenium (Ru) increases from the multilayer reflective film 50 side toward the side away from the multilayer reflective film 50 in the partial or entire protective film 110 in the thickness direction. In particular, in a case where niobium (Nb) is contained as a metal or a metalloid different from ruthenium (Ru), the content of niobium (Nb) is preferably increased from the multilayer reflective film 50 side toward the side away from the multilayer reflective film 50 in the partial or entire protective film 110 in the thickness direction since the content of niobium (Nb) is also effective in improving resistance to dry etching using a gas containing chlorine (Cl) and oxygen (O).

Note that, in the present embodiment, specific examples of the dry etching using a gas containing chlorine (Cl) and oxygen (O) include dry etching using a gas containing a chlorine (Cl₂) gas and an oxygen (O₂) gas. The gas containing chlorine (Cl) and oxygen (O) may contain a rare gas such as a helium (He) gas, an argon (Ar) gas, a krypton (Kr) gas, or a xenon (Xe) gas.

A thickness of the protective film 110 is preferably 2 nm or more and more preferably 3 nm or more and preferably 5 nm or less and more preferably 4 nm or less. In a case where the thickness of the protective film 110 is less than 2 nm, the function of protecting the multilayer reflective film 50 becomes insufficient, and in a case where the thickness thereof exceeds 5 nm, the reflectance of the EUV light decreases.

The protective film 110 can be formed by performing the sputtering by appropriately selecting from and using, as a target, a ruthenium (Ru) target, a target made of a metal or a metalloid different from ruthenium (Ru), specifically, a niobium (Nb) target, a rhenium (Re) target, a zirconium (Zr) target, a titanium (Ti) target, a chromium (Cr) target, a silicon (Si) target, a target obtained by mixing two or more kinds selected from niobium (Nb), rhenium (Re), zirconium (Zr), titanium (Ti), chromium (Cr), and silicon (Si), a target obtained by mixing ruthenium (Ru) and one or more metals or metalloids different from ruthenium (Ru) selected from niobium (Nb), rhenium (Re), zirconium (Zr), titanium (Ti), chromium (Cr), and silicon (Si), or the like, and using, as a sputtering gas, a rare gas such as a helium (He) gas, an argon (Ar) gas, a krypton (Kr) gas, or a xenon (Xe) gas. The sputtering is preferably the magnetron sputtering.

After the multilayer reflective film 50 or the protective film 110 is formed, heat treatment may be performed, and it is possible to reduce fluctuations in characteristics such as the reflectance with respect to the EUV light in a case where heat is applied at the time of forming a mask pattern by performing the heat treatment. A heat treatment temperature is preferably 120°C or more and 150°C or lower in general, and a temperature higher than 150°C is not preferable because the reflectance of the EUV light is decreased.

The heat treatment may be performed either or both of after the multilayer reflective film 50 is formed or after the protective film 110 is formed, but the fewer times the heat treatments the better from the viewpoint of concern of defective substance adhesion, productivity, or the like, and the heat treatment is preferably performed after the protective film 110 is formed.

Meanwhile, in a case where the heat treatment is performed after the protective film 110 is formed, an oxide film is formed on a front surface of the protective film 110, and the reflectance with respect to the pattern inspection light may be reduced. In addition, even in a case where the heat treatment is not performed after the protective film 110 is formed, a surface layer of the protective film 110 can be sufficiently oxidized after the pattern formation. Hence, it is necessary to set the reflectance of the absorption film with respect to the pattern inspection light to the reflectance obtained by assuming that the protective film 110 is oxidized.

As illustrated in FIGS. 1 and 2, a conductive film (back conductive film 150) used for electrostatic chucking of the reflective mask in an exposure device (for example, an EUV scanner) may be provided on the other main surface (back surface) which is a surface opposite to the one main surface (front surface) of the substrate 10, preferably in contact with the other main surface.

The back conductive film 150 preferably has sheet resistance of 100 Ω/□ or lower, and there is no particular limitation on the material thereof. Examples of the material of the back conductive film 150 include a material containing tantalum (Ta) or chromium (Cr). In addition, the material containing tantalum (Ta) may contain oxygen (O), nitrogen (N), carbon (C), boron (B) or the like, and the material containing chromium (Cr) may contain oxygen (O), nitrogen (N), carbon (C), or the like. Examples of the material containing tantalum (Ta) include elemental Ta and tantalum (Ta) compounds such as TaO, TaN, TaON, TaC, TaCN, TaCO, TaCON, TaB, TaOB, TaNB, TaONB, TaCB, TaCNB, TaCOB, and TaCONB. Specific examples of the material containing chromium (Cr) include elemental Cr and chromium (Cr) compounds such as CrO, CrN, CrON, CrC, CrCN, CrCO, and CrCON.

A thickness of the back conductive film 150 is not particularly limited as long as the back conductive film fulfills a function for an electrostatic chuck, but is usually about 20 to 300 nm. It is preferable that, after the back conductive film 150 is formed as the reflective mask, that is, after a pattern of the absorption film is formed, the thickness of the back conductive film 150 is set to balance film stress with the film and the pattern of the film formed on the one main surface (front surface) side. The back conductive film 150 may be formed before the multilayer reflective film 50 is formed, or may be formed after all the films on the multilayer reflective film 50 side of the substrate 10 are formed. In addition, after some of the films on the multilayer reflective film 50 side of the substrate 10 are formed, the back conductive film 150 may be formed, and then the remaining films on the multilayer reflective film 50 side of the substrate 10 may be formed. The back conductive film 150 can be formed by, for example, the magnetron sputtering method.

### [Examples]

Hereinafter, the present invention will be described specifically with reference to an experimental example and comparative examples, but the present invention is not limited to the experimental examples. In addition, film formation needs to be performed on the multilayer reflective film 50, the protective film 110, or the absorber film 120 depending on an original function of the reflective mask blank, but in the experimental example, film formation is simply performed on the quartz substrate 10 in order to compare interface states of the multilayer structures. The same effects of the present invention can be achieved on both the quartz substrate 10 and the layers.

### [Example 1]

On the main surface of the quartz glass substrate 10 having a size of 152 mm × 152 mm and a thickness of 6.35 mm, the multilayer film 200 containing Ta which functions as any one of the absorber film 120 of the reflective mask blank, the hard mask film 130, and the buffer layer in the absorber film 120 was formed by DC pulsed magnetron sputtering while the substrate 10 rotates. Note that the buffer layer is used to prevent an underlying film from being directly exposed to an etching gas and reduce a film loss of the underlying film when an upper film is processed by etching.

The quartz glass substrate 10 was loaded in a chamber, an Ar gas (40 vol%) and an N₂ gas (60 vol%) were first introduced, chamber pressure was set to 0.48 Pa, and power of 1,800 W was applied to a tantalum (Ta) target, and a TaN layer (TaN part 210) was formed. Subsequently, an Ar gas (100 vol%) was introduced in a state in which the substrate 10 remained as loaded in the chamber, and condition switching was performed to conditions in which the chamber pressure was 0.07 Pa, and power of 500 W was applied to the tantalum (Ta) target, so that the Ta layer (Ta part 220) having a thickness of 1 nm was formed. Subsequently, an Ar gas (30 vol%) and an O₂ gas (70 vol%) were introduced into the same chamber, and condition switching was performed to conditions in which chamber pressure was set to 0.15 Pa, and power of 500 W was applied to the tantalum (Ta) target, so that the TaO layer (TaO part 230) having a thickness of 4.5 nm was formed.

As a result of calculating densities and film thicknesses of the layers of the obtained multilayer film 200 containing Ta by using the X-ray reflectivity technique (XRR) by an X-ray diffractometer (SmartLab manufactured by Rigaku Corporation), the TaN layer had a film thickness of 20.7 nm and a density of 11.0 g/cm³. The Ta layer had a film thickness of 1.0 nm and a density of 13.0 g/cm³. The TaO layer had a film thickness of 4.8 nm and a density of 8.2 g/cm³.

The composition of the obtained multilayer film 200 containing Ta was measured by an X-ray photoelectron spectrometer (XPS) system (K-Alpha manufactured by Thermo Fisher Scientific Inc.), and in the TaN layer, tantalum (Ta) was 45 atom%, and nitrogen (N) was 55 atom%, with respect to the total of tantalum (Ta) and nitrogen (N), and in the TaO layer, tantalum (Ta) was 34 atom%, and oxygen (O) was 66 atom%, with respect to the total of tantalum (Ta) and oxygen (O).

Regarding the obtained multilayer film 200, a cross section including a part of the substrate 10 and the entire multilayer film 200 was cut out with a focused ion beam (FIB) apparatus (Helios G4 CX manufactured by FEI Company) and was observed with a transmission electron microscope (TEM) (ARM200F manufactured by JEOL Ltd.). As a result, precipitation of crystals or the like was not observed between the TaN layer and the TaO layer, and the layers were smoothly formed. Since the roughness of the front surfaces of the TaN layer, the Ta layer, and the TaO layer is decreased in this manner, the defect inspection sensitivity can be improved.

### [Example 2]

On the main surface of the quartz glass substrate 10 having a size of 152 mm × 152 mm and a thickness of 6.35 mm, the multilayer film 200 containing Ta which functions as any one of the absorber film 120 of the reflective mask blank, the hard mask film 130, and the buffer layer in the absorber film 120 was formed in the same manner as in Example 1 except that the Ta layer (TaO part 230) had a thickness of 2 nm.

As a result of calculating densities and film thicknesses of the layers of the obtained multilayer film 200 containing Ta by using the XRR in the same manner as in Example 1, the TaN layer had a film thickness of 21.0 nm and a density of 10.9 g/cm³. The Ta layer had a film thickness of 1.1 nm and a density of 16.6 g/cm³. The TaO layer had a film thickness of 4.5 nm and a density of 8.3 g/cm³.

Similarly to Example 1, precipitation of crystals or the like was not observed between the TaN layer and the TaO layer with the transmission electron microscope, and the layers were smoothly formed. Since the roughness of the front surfaces of the TaN layer, the Ta layer, and the TaO layer is decreased in this manner, the defect inspection sensitivity can be improved.

### [Example 3]

On the main surface of the quartz glass substrate 10 having a size of 152 mm × 152 mm and a thickness of 6.35 mm, the multilayer film 200 containing Ta which functions as any one of the absorber film 120 of the reflective mask blank, the hard mask film 130, and the buffer layer in the absorber film 120 was formed.

First, the TaN layer was formed in the same conditions as in Example 1. Similarly, the Ta layer having a film thickness of 2 nm was formed in the same conditions as in Example 1. Thereafter, without forming the TaO layer, a heat treatment was performed at 150°C for 15 minutes in the atmosphere by a hot plate type heating device to oxidize a surface part of the protective film 110, thereby forming the TaO layer.

As a result of calculating densities and film thicknesses of the layers of the obtained multilayer film 200 containing Ta by using the XRR in the same manner as in Example 1, the TaN layer had a film thickness of 29.5 nm and a density of 11.2 g/cm³. The Ta layer had a film thickness of 2.2 nm and a density of 16.6 g/cm³. The TaO layer had a film thickness of 1.3 nm and a density of 3.7 g/cm³.

As a result of observation with the transmission electron microscope in the same manner as in Example 1, precipitation of crystals or the like was not observed between the TaN layer and the TaO layer, and the layers were smoothly formed. Since the roughness of the front surfaces of the TaN layer, the Ta layer, and the TaO layer is decreased in this manner, the defect inspection sensitivity can be improved.

### [Comparative Example 1]

On the main surface of the quartz glass substrate 10 having a size of 152 mm × 152 mm and a thickness of 6.35 mm, the multilayer film 200 containing Ta which functions as any one of the absorber film 120 of the reflective mask blank, the hard mask film 130, and the buffer layer in the absorber film 120 was formed. First, the TaN layer was formed in the same conditions as in Example 1. Next, without forming the Ta layer, the TaO layer having a film thickness of 4 nm was formed in the same conditions as in Example 1.

As a result of calculating densities and film thicknesses of the layers of the obtained multilayer film 200 containing Ta by using the XRR, similarly to Example 1, the TaN layer had a film thickness of 21.9 nm and a density of 10.9 g/cm³. The TaO layer had a film thickness of 2.1 nm and a density of 8.4 g/cm³.

As a result of observation with the transmission electron microscope in the same manner as in Example 1, any layer of the TaN layer and the TaO layer which was regarded as a layer in which precipitation of crystals occurred was formed with a different density, and the interface was unevenly formed. Since the roughness of the front surfaces of the TaN layer and the TaO layer is increased in this manner, the defect inspection sensitivity is degraded.

### [Comparative Example 2]

On the main surface of the quartz glass substrate 10 having a size of 152 mm × 152 mm and a thickness of 6.35 mm, the multilayer film 200 containing Ta which functions as any one of the absorber film 120 of the reflective mask blank, the hard mask film 130, and the buffer layer in the absorber film 120 was formed in the same manner as in Example 1 except that the Ta layer had a thickness of 0.5 nm.

As a result of calculating densities and film thicknesses of the layers of the obtained multilayer film 200 containing Ta by using the XRR in the same manner as in Example 1, the TaN layer had a film thickness of 21.3 nm and a density of 10.9 g/cm³. The Ta layer had a film thickness of 0.5 nm and a density of 12.0 g/cm³. The TaO layer had a film thickness of 4.8 nm and a density of 7.3 g/cm³.

As a result of observation with the transmission electron microscope in the same manner as in Example 1, any layer of the TaN layer and the TaO layer which was regarded as a layer in which precipitation of crystals occurred was formed with a different density, and the interface was unevenly formed. Since the roughness of the front surfaces of the TaN layer, the Ta layer, and the TaO layer is increased in this manner, the defect inspection sensitivity is degraded.

### [Comparative Example 3]

On the main surface of the quartz glass substrate 10 having a size of 152 mm × 152 mm and a thickness of 6.35 mm, the multilayer film 200 containing Ta which functions as any one of the absorber film 120 of the reflective mask blank, the hard mask film 130, and the buffer layer in the absorber film 120 was formed.

First, the TaN layer was formed in the same conditions as in Example 1. Next, a Ta layer was not formed, and an Ar gas (22 vol%), an O₂ gas (56 vol%), and a N₂ gas (22 vol%) were introduced into the same chamber, and condition switching was performed to conditions in which chamber pressure was set to 0.18 Pa, and power of 500 W was applied to the tantalum (Ta) target, so that a TaON layer having a thickness of 4.7 nm was formed.

As a result of calculating densities and film thicknesses of the layers of the obtained multilayer film 200 containing Ta by using the XRR, similarly to Example 1, the TaN layer had a film thickness of 21.9 nm and a density of 11.0 g/cm³. The TaON layer had a film thickness of 4.7 nm and a density of 7.3 g/cm³.

As a result of observation with the transmission electron microscope in the same manner as in Example 1, the entire TaON layer was formed with a crude density, and this was not a preferable state. Since the roughness of the front surface of the TaON layer is increased when the TaON layer has the crude density in this manner, the defect inspection sensitivity is degraded.

### Reference Signs List

- 10: Substrate
- 20: High-refractive-index layer
- 30: Low-refractive-index layer
- 50: Multilayer reflective film
- 51: Cyclic lamination structure
- 110: Protective film
- 120: Absorber film
- 130: Hard mask film
- 200: Multilayer film
- 200a: First multilayer film (absorber film)
- 200b: Second multilayer film (hard mask film)
- 210: TaN part
- 220: Ta part
- 230: TaO part

## Claims

1. A reflective mask blank used in EUV lithography using EUV light as exposure light comprising at least a substrate (10); a multilayer reflective film (50) that is formed on the substrate (10) and reflects exposure light; and a multilayer film (200) containing tantalum (Ta),
wherein the multilayer film (200) has a TaN part (210), a TaO part (230), and a Ta part (220) provided between the TaN part (210) and the TaO part (230),
wherein a density of the Ta part (220) is higher than densities of the TaN part (210) and the TaO part (230), and
wherein the density of the Ta part (220) is 13 g/cm³ or more.

2. The reflective mask blank according to claim 1,
wherein the TaN part (210), the Ta part (220), and the TaO part (230) are laminated in this order from the substrate side in the multilayer film (200).

3. The reflective mask blank according to claim 1 or 2,
wherein a film thickness of the Ta part (220) is 1 nm or more and less than 3 nm.

4. The reflective mask blank according to any one of claims 1 to 3,
wherein the TaN part (210) is substantially free of oxygen and contains less than 70 atom% of tantalum (Ta) and more than 30 atom% of nitrogen (N).

5. The reflective mask blank according to any one of claims 1 to 4,
wherein the TaO part (230) is substantially free of nitrogen (N), and contains less than 70 atom% of tantalum (Ta) and more than 30 atom% of oxygen (O) or
wherein the TaO part (230) contains less than 5 atom% of any one or more kinds of boron (B), carbon (C), hydrogen (H), and silicon (Si) in addition to tantalum (Ta) and oxygen (O).

6. The reflective mask blank according to any one of claims 1 to 5,
wherein the Ta part (220) contains substantially no element other than tantalum (Ta), or
wherein a total content of nitrogen (N) and oxygen (O) is less than 20 atom% in the Ta part (220).

7. The reflective mask blank according to any one of claims 1 to 6,
wherein the multilayer film (200) functions as an absorber film.

8. The reflective mask blank according to claim 7 further comprising a hard mask film that is used as an etching mask during processing of the multilayer film (200) functioning as the absorber film,
wherein the hard mask film contains chromium (Cr).

9. The reflective mask blank according to any one of claims 1 to 8,
wherein the multilayer film (200) has a first multilayer film (200a) having a first TaN part (210a), a first TaO part (230a), and a first Ta part (220a) provided between the first TaN part (210a) and the first TaO part (230a), and a second multilayer film (200b) having a second TaN part (210b), a second TaO part (230b), and a second Ta part (220b) provided between the second TaN part (210b) and the second TaO part (230b),
wherein the first multilayer film (200a) functions as an absorber film,
wherein the second multilayer film (200b) functions as a hard mask film used as an etching mask during processing of the first multilayer film (200a) that is the absorber film,
wherein a film thickness of the first multilayer film (200a) is 55 nm or more and less than 70 nm, and
wherein a film thickness of the second multilayer film (200b) is 20 nm or less.

10. A method for manufacturing the reflective mask blank according to any one of claims 1 to 9,
wherein the Ta part (220) is formed between the TaN part (210) and the TaO part (230) by forming a film of Ta under oxygen- and nitrogen-free atmosphere.

11. The method for manufacturing the reflective mask blank according to claim 10,
wherein the film of Ta is formed under the oxygen- and nitrogen-free atmosphere to form the Ta part (220) after the TaN part (210) is formed, and
wherein a surface of the Ta part (220) on a side away from the substrate (10) is oxidized to form the TaO part (230).
